# EUROPEAN PATENT APPLICATION

(11) **EP 4 462 138 A1**
(43) Date of publication of application: **13.11.2024**
(21) Application number: 23877500.1
(22) Date of filing: 08.09.2023
(51) Int. Cl.: G01R 31/364, G01R 31/3842, G01R 31/371, G01R 15/20, G01R 15/14, G01R 19/257, G01R 19/00, G01R 19/165, G01R 31/36, G08B 21/18

(54) **INTEGRATED CURRENT SENSING DEVICE AND BATTERY PACK INCLUDING SAME**

(30) Priority: 11.10.2022 KR 20220129776
(71) Applicant: LG Energy Solution, Ltd., Seoul 07335 (KR)
(72) Inventor: LEE, Young Jun, Daejeon 34122 (KR)
(74) Representative: Goddar, Heinz J.
(86) International application number: PCT/KR2023/013531
(87) International publication number: WO 2024/080570

(57) **Abstract**

The present invention relates to an integrated current sensing device including a case having a plurality of slots, a sensor board having a sensor connector configured to connect at least one sensor board mounted in the slots, and a mainboard having a means configured to communicate with a BMS and a control means and a battery pack including the same.

## Description

### [Technical Field]

This application claims the benefit of priority to Korean Patent Application No. 2022-0129776 filed on October 11, 2022, the disclosure of which is incorporated herein by reference in its entirety.

The present invention relates to an integrated current sensing device and a battery pack including the same, and more particularly to an integrated current sensing device including a sensor board configured to connect at least one current sensing module and a mainboard having a means configured to communicate with a BMS and a means configured to control the current sensing module and a battery pack including the same.

### [Background Art]

The capacities of secondary batteries used as energy sources of various kinds of electronic devices inevitably used in modern society have been increased due to an increase in usage of mobile devices, increasing complexity of the mobile devices, and development of electric vehicles. In order to satisfy demand of users, a plurality of battery cells is disposed in a small-sized device, whereas a battery module including a plurality of battery cells electrically connected to each other or a battery pack including a plurality of battery modules is used in a vehicle.

A battery pack using such a secondary battery is provided with a current sensor configured to measure current. The current sensor measures current that flows along a charging and discharging path of the battery pack to monitor the state of the battery pack and to detect overcurrent that flows in the battery pack.

The current measured by the current sensor may be transmitted to a battery management system (BMS) so as to be used as information necessary to calculate SOC or as a basis for determining whether a charging and discharging process is normally proceeding.

However, the current sensor needs to be provided at each of a plurality of battery modules, and the measured amount of current needs to be individually transmitted to the BMS. As a result, each current sensor is provided with an additional circuit configured to communicate with the BMS, which increases the cost.

Also, in order to increase the safety level, it is necessary to dispose at least two current sensors in order to perform determination through comparison of error of measured values, or when the current sensor is abnormal due to vibration or impact and stable measurement is difficult, duplexing through an auxiliary sensor is necessary, and therefore it is necessary to dispose a plurality of current sensors so as to be adjacent to each other.

Patent Document 1 is characterized in that a BMS directly controls a current sensor, wherein the BMS and one current sensor are directly electrically connected to a power supply line, a GND line, and an output voltage line. This leads to the problem that, as the number of current sensors provided in a battery pack increases, the load applied to the BMS also increases.

### (Prior Art Document)

(Patent Document 1) Korean Patent Application Publication No. 2017-0077713

### [Disclosure]

### [Technical Problem]

The present invention has been made in view of the above problems, and it is an object of the present invention to provide an integrated current sensing device having an integrated board for connection of a plurality of current sensors with only minimal circuitry configured to measure current, communication with a BMS, and control and a battery pack including the same.

### [Technical Solution]

An integrated current sensing device according to the present invention to accomplish the above object may include at least one current sensing module (400), a case (100) having a plurality of slots (110), at least one sensor board (300) mounted in the plurality of slots (110), and a mainboard (200) having a communication and control means, wherein the at least one sensor board (300) has a sensor connector (310) configured to allow the at least one current sensing module (400) to be connected thereto.

Also, in the integrated current sensing device according to the present invention, the at least one sensor board (300) may transmit signals measured by the at least one current sensing module (400) to the mainboard (200).

Also, in the integrated current sensing device according to the present invention, the mainboard (200) may include a main controller (210) configured to collect and determine the measured signals received from the at least one sensor board (300) and a signal transmission unit (220) configured to communicate with a BMS.

Also, in the integrated current sensing device according to the present invention, the at least one current sensing module (400) may include a connection terminal (405) and may be connected to the sensor connector (310) of the at least one sensor board (300).

Also, in the integrated current sensing device according to the present invention, the at least one current sensing module (400) may be a Hall type current sensor, a flux gate type current sensor, or a shunt type current sensor.

Also, in the integrated current sensing device according to the present invention, the at least one sensor board (300) may be separately configured for each type of the at least one current sensing module (400).

Also, in the integrated current sensing device according to the present invention, the case (100) may further include an upper cover (120) having a connection recess (130) and an external connection portion (140) configured to communicate with the BMS.

Also, in the integrated current sensing device according to the present invention, the sensor connector (310) may protrude into the connection recess (130) so as to be connected to the at least one current sensing module (400).

Also, in the integrated current sensing device according to the present invention, the at least one sensor board (300) and the at least one current sensing module (400) may exclude a means configured to communicate with a BMS.

In addition, a current measurement method using the integrated current sensing device according to the present invention may include a first step of receiving, by the at least one sensor board (300), the amount of current measured by the at least one current sensing module (400), a second step of digitally converting, by the at least one sensor board (300), the measured amount of current and transmitting a current value to the mainboard (200), a third step of comparing, by the mainboard (200), the received current value with a pre-stored threshold value to determine whether the current value is abnormal, and a fourth step of, upon determining that the current value is abnormal, notifying the BMS of the abnormal current value and generating an alarm.

### [Advantageous Effects]

As is apparent from the above description, an integrated current sensing device according to the present invention and a battery pack including the same have an advantage in that means for communication with a BMS and connection connectors to be commonly provided at current sensors are integrated into one, whereby it is possible to minimize related redundant parts, and therefore it is possible to reduce manufacturing cost of the current sensors.

In addition, the integrated current sensing device according to the present invention and the battery pack including the same have a merit in that it is possible to collect and determine current values measured by the respective current sensors before transmission thereof to the BMS, whereby it is possible to minimize the load applied to the BMS.

Furthermore, the integrated current sensing device according to the present invention and the battery pack including the same have an advantage in that various kinds of sensors in the battery pack, such as a temperature sensor and an electrolyte leakage sensor, are integrated in addition to the current sensors, and then transmission to the BMS is performed, whereby it is possible to simplify wire connection for communication.

### [Description of Drawings]

FIG. 1 is a view showing a connection configuration between a current sensor and a BMS according to a related art.
FIG. 2 is a perspective view of an integrated current sensing device according to a preferred embodiment of the present invention.
FIG. 3 is an exploded perspective view of the integrated current sensing device of FIG. 2.
FIG. 4 is a view showing an inner configuration of the integrated current sensing device according to the preferred embodiment of the present invention.
FIG. 5 is a view showing an example of current measurement using the integrated current sensing device according to the preferred embodiment of the present invention.
FIG. 6 is a flowchart showing current measurement using the integrated current sensing device according to the preferred embodiment of the present invention.

### [Best Mode]

Now, preferred embodiments of the present invention will be described in detail with reference to the accompanying drawings such that the preferred embodiments of the present invention can be easily implemented by a person having ordinary skill in the art to which the present invention pertains. In describing the principle of operation of the preferred embodiments of the present invention in detail, however, a detailed description of known functions and configurations incorporated herein will be omitted when the same may obscure the subject matter of the present invention.

In addition, the same reference numbers will be used throughout the drawings to refer to parts that perform similar functions or operations. In the case in which one part is the to be connected to another part in the entire specification, not only may the one part be directly connected to the other part, but also, the one part may be indirectly connected to the other part via a further part. In addition, that a certain element is included does not mean that other elements are excluded, but means that such elements may be further included unless mentioned otherwise.

Hereinafter, an integrated current sensing device according to the present invention will be described with reference to the accompanying drawings.

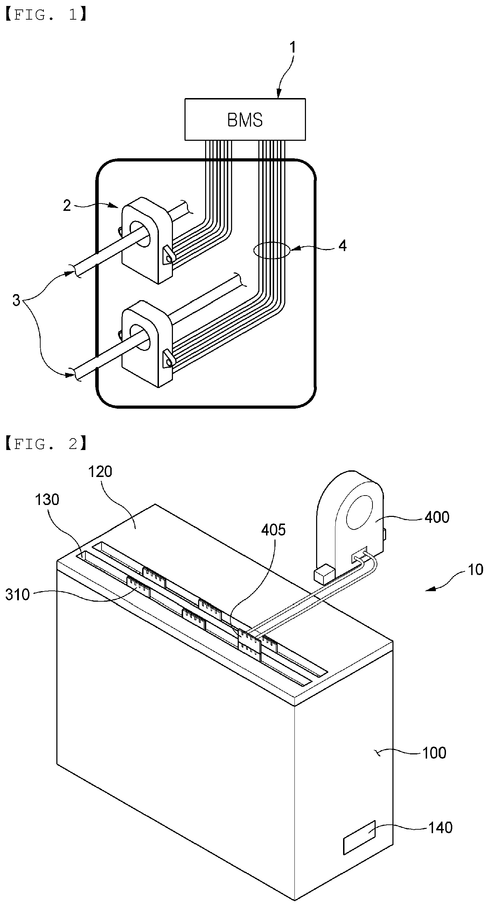

FIG. 1 shows a plurality of current sensors 2 capable of communicating with a BMS 1 according to a related art, wherein each current sensor 2, which measures the amount of current in an electric wire 3, further requires an additional line (see reference numeral 4) and a communication circuit part for communication with the BMS and a circuit part that amplifies the amount of current for each type of current sensor in addition to power lines VCC and GND, which increases the cost.

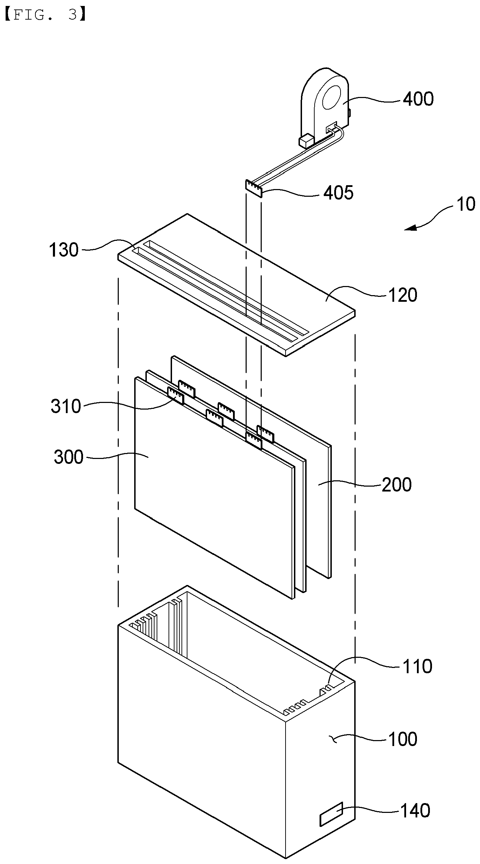

FIG. 2 is a perspective view of an integrated current sensing device according to a preferred embodiment of the present invention, and FIG. 3 is an exploded perspective view of FIG. 2.

As shown in FIGs. 2 and 3, the integrated current sensing device according to the embodiment of the present invention includes a case 100 including a mainboard 200 and a sensor board 300 and a current sensing module 400 connected to the case outside the case via a wire.

First, the case 100 includes a plurality of slots 110 configured to fix, mount, and electrically connect various kinds of boards to each other and an upper cover 120 configured to be opened and closed.

In addition, the case 100 has a separate external connection portion 140 to provide various connection means for power supply and communication with the outside, in particular with the BMS. Preferably, a wire-connectable connector for power supply and communication with the BMS is provided, and an antenna for wireless communication may be further provided.

Although not shown in FIGs. 2 and 3, each slot 110 may be provided with a bus-type circuit to enable the transmission and reception of a signal and the supply of power between the mainboard 200 and at least one sensor board 300, and may be expandable as needed. This can be easily designed by those skilled in the art, and therefore a detailed description thereof will be omitted.

The upper cover 120 is provided with a plurality of connection recesses 130, and at least one sensor connector 310 provided at the sensor board 300 may be easily exposed to the outside through the connection recesses 130, thereby achieving easy engagement with a connection terminal 405 provided at the wire end of the current sensing module 400. The position of the connection recesses 130 may be variously changed depending on the position of the sensor connector 310 provided at the sensor board 300.

The case 100 may be configured in various forms depending on the position of the slots. For example, as in a conventional general purpose personal computer, the mainboard 200 may not be mounted in a separate slot like a motherboard, and the sensor board 300 may be connected in the form of a daughterboard like a slot for mounting a memory module provided in the motherboard. Consequently, the shape of the case 100 and the slots 110 may be variously changed by those skilled in the art without limitation.

Referring to FIGs. 2 and 3, the current sensing module 400 includes a wire and a connection terminal 405 for connection to the sensor board 300.

In addition, the current sensing module 400 is classified as a non-contact type current sensor or a contact type current sensor according to the use and purpose, and is also classified as a Hall current sensor that measures the magnitude of a magnetic field generated in a core by current that flows in an electric wire, a flux gate current sensor that convert a magnetic field generated around current into voltage through the Hall effect using a magneto impedance (MI) element to measure the voltage, or a direct-connection type shunt current sensor that detects resistance that converts voltage drop by a shunt resistor into current.

The sensor board 300 for connecting these current sensing modules 400 can connect all of current sensing modules regardless of the type of current sensing module 400. Preferably, however, a separate sensor board 300 is provided for each of the Hall current sensor, the flux gate current sensor, and the shunt current sensor. Consequently, it is possible to simplify the circuitry of the sensor board 300 having a plurality of one-type current sensors.

In addition, the number of wires connected to the current sensing module 400 and the connectors 405 and 310 may be variously configured, and therefore various modifications are possible without being limited to those shown in FIGs. 2 and 3.

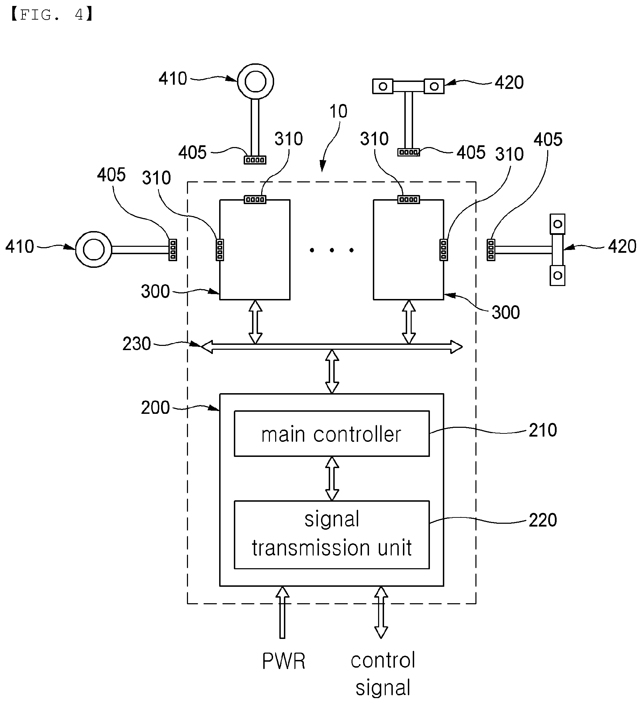

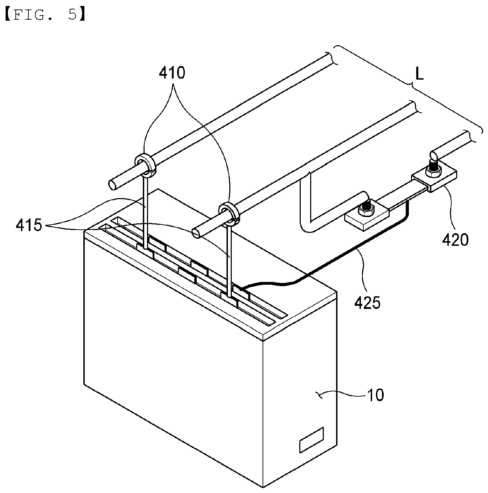

Hereinafter, the detailed functions and configurations of the current sensing module 400, the sensor board 300, and the mainboard 200 will be described in detail with reference to FIGs. 4 and 5.

FIG. 4 is a view showing an inner configuration of the integrated current sensing device according to the preferred embodiment of the present invention.

Referring to FIG. 4, a mainboard 200 and at least one sensor board 300 having a sensor connector 310 for connection of various kinds of current sensing modules 400 are included in the case 100 of the integrated current sensing device 10.

The sensor board 300 and the mainboard 200, each of which is manufactured using a PCB board, may be connected to a connection bus 230. However, one sensor board 300 and the mainboard 200 may be directly connected to each other using a circuit pattern on the PCB rather than in the form of a bus, which may be easily designed by those skilled in the art, and therefore there is no restriction on the structure of the connection between the sensor board 300 and the mainboard 200.

In addition, the sensor board 300 may be differently configured depending on the type of the current sensing module 400, and may connect at least one current sensing module 400.

A general Hall current sensor includes a Hall element configured to generate current (or voltage) proportional to a change in a magnetic field concentrated by a magnetic core through which an electric wire having current flowing therein extends and an A/D converter configured to convert and output an analog current value output from the Hall element into digital current data. The digital current data converted and output thereby is generated and compared with a predetermined data value, and the result is transmitted to the BMS.

In FIG. 4, the Hall current sensor 410 may only perform the function of the Hall element and the function of transmitting the analog current value output from the Hall element to the sensor board 300. The sensor board 300 performs the function of the A/D converter that converts and outputs the analog current value into digital current data and the function of generating a digital current value converted and output thereby.

Meanwhile, the shunt current sensor 420, which is disposed between a positive (+) end of the battery and a load, lowers voltage through the shunt resistor connected thereto, calculates the voltage difference measured at both ends of the shunt resistor through the lowered voltage signal, and calculates current through the calculated voltage difference. The current is calculated using Ohm's law through the resistance value of the shunt resistor and the voltage difference at both ends of the shunt resistor, which is known technology, and therefore a detailed description thereof will be omitted.

However, the shunt current sensor must be constituted by a circuit including an element configured to allow an MCU to perform an operation of predicting the state of the battery based on current through a voltage signal lowering and current measurement means. In addition, a transmission means configured to transmit the result of the operation to the BMS must also be included in one sensor.

To solve this problem, the shunt current sensor 420 in FIG. 4 only measures the voltage at both ends of the shunt resistor and transmits the measured voltage to the sensor board 300, the sensor board 300 is provided with a voltage drop and current measurement means, and a calculation and BMS transmission circuit is provided at the mainboard 200, whereby it is possible to prevent duplication of circuit parts in the case of at least two current sensors.

Referring to FIG. 4, the mainboard 200 includes a main controller 210 and a signal transmission unit 220. Although not shown in FIG. 4, a microcontroller unit (MCU) therefor may be included, and a separate power supply and connection means for connecting with the sensor board 300 may be provided.

The main controller 210 may perform control such that the current sensor measures current periodically at a predetermined time interval through the sensor board 300 or may compare a measurement value of the current transmitted from the sensor board 300 with a pre-stored threshold value to determine whether the current is abnormal or whether the current sensor malfunctions. Consequently, the main controller may perform some of the functions of the BMS.

In addition, the signal transmission unit 220 includes a communication circuit and protocol configured to transmit data to be transmitted from the main controller 210 to the BMS.

FIG. 5 is a view showing an example of current measurement using the integrated current sensing device according to the preferred embodiment of the present invention.

Referring to FIG. 5, the current sensing module 400 is divided into the Hall current sensor 410 and the shunt current sensor 420, which may be connected to different sensor boards 300 via wires 415 and 425.

In addition, the Hall current sensor 410 and the shunt current sensor 420 may simultaneously measure current for each of the current lines L connected in parallel, and errors of current measurement therebetween may be compared by the main controller 210 of the mainboard 200, not by the BMS, such that short circuit or current leakage can be immediately determined. In a state having a normal current value, separate notification to the BMS may not be necessary, and measurement by the mainboard 200 without control of the BMS may also be possible.

In a preferred modification of the present invention, the sensor board 300 may further include an interface for connection to various sensors in the battery pack, such as a temperature sensor, a voltage sensor, and a humidity sensor, in addition to the current sensing module 400. In this case, values sensed, i.e., measured, by the respective sensors may be further transmitted to the mainboard 200, and the mainboard 200 may provide a control and determination function suitable for each sensor and a means for connection to the BMS.

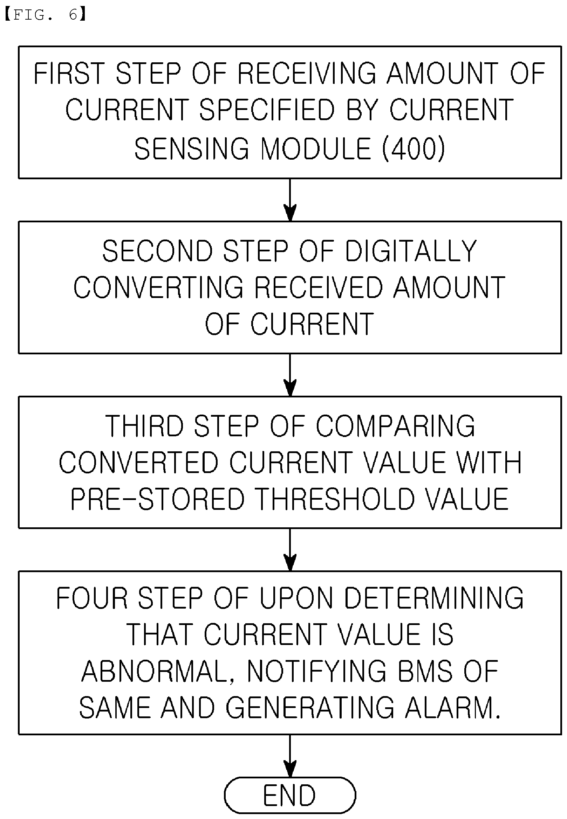

FIG. 6 is a flowchart showing current measurement using the integrated current sensing device according to the preferred embodiment of the present invention.

The current measurement method using the integrated current sensing device according to the preferred embodiment of the present invention may include a first step of receiving, by the sensor board 300, the amount of current measured by the at least one current sensing module 400, a second step of digitally converting, by the sensor board 300, the measured amount of current and transmitting a current value to the mainboard 200, a third step of comparing, by the mainboard 200, the received current value with a pre-stored threshold value to determine whether the current value is abnormal, and a fourth step of, upon determining that the current value is abnormal, notifying the BMS of the same and generating an alarm.

Specifically, the first step is a step in which the sensor board 300 receives an analog current value output from the Hall element or the shunt resistor in the at least one current sensing module 400, and the second step is a step in which the sensor board 300 converts and outputs the analog current value into digital current data through A/D conversion, generating a digital current value converted and output thereby, and transmitting the digital current value to the mainboard 200.

The third step is a step in which the mainboard 200 determines whether the current value received from the sensor board 300 is abnormal. The measured current value is compared with a threshold value of the current value of the current sensing module 400 stored in advance, and when the measured current value exceeds a threshold range, the mainboard determines that the current value is abnormal. Upon determining that the current value is abnormal, the fourth step of notifying the BMS of the same and generating an alarm may be performed. Upon determining that the current value is normal, the first step may be repeatedly performed.

The mainboard 200 may repeatedly operate the current sensing module 400 at a predetermined cycle, or may selectively operate the current sensing module 400 in response to a control signal from the BMS as needed.

The present invention has been described above with reference to specific embodiments. However, those skilled in the art to which the present invention pertains will appreciate that various applications and modifications are possible within the category of the present invention based on the above description.

### (Description of Reference Symbols)

- 10:: Integrated current sensing device
- 100:: Case
- 110:: Slot
- 120:: Upper cover
- 130:: Connection recess
- 140:: External connection portion
- 200:: Mainboard
- 210:: Main controller
- 220:: Signal transmission unit
- 230:: Connection bus
- 300:: Sensor board
- 310:: Sensor connector
- 400:: Current sensing module
- 405:: Connection terminal
- 410:: Hall current sensor
- 415, 425:: Wires
- 420:: Shunt current sensor
- L:: Current line

## Claims

1. An integrated current sensing device comprising:
at least one current sensing module;
a case having a plurality of slots;
at least one sensor board mounted in the plurality of slots; and
a mainboard having a communication and control means,
wherein the at least one sensor board has a sensor connector configured to allow the at least one current sensing module to be connected thereto.

2. The integrated current sensing device according to claim 1, wherein the at least one sensor board transmits signals measured by the at least one current sensing module to the mainboard.

3. The integrated current sensing device according to claim 2, wherein the mainboard comprises:
a main controller configured to collect and determine the measured signals received from the at least one sensor board; and
a signal transmission unit configured to communicate with a BMS.

4. The integrated current sensing device according to claim 1, wherein the at least one current sensing module comprises a connection terminal and is connected to the sensor connector of the at least one sensor board.

5. The integrated current sensing device according to claim 1, wherein the at least one current sensing module is a Hall type current sensor, a flux gate type current sensor, or a shunt type current sensor.

6. The integrated current sensing device according to claim 5, wherein the at least one sensor board is separately configured for each type of the at least one current sensing module.

7. The integrated current sensing device according to claim 1, wherein the case further comprises an upper cover having a connection recess and an external connection portion configured to communicate with a BMS.

8. The integrated current sensing device according to claim 1, wherein the sensor connector protrudes into the connection recess so as to be connected to the at least one current sensing module.

9. The integrated current sensing device according to claim 1, wherein the at least one sensor board and the at least one current sensing module exclude a means configured to communicate with a BMS.

10. A current measurement method using the integrated current sensing device according to any one of claims 1 to 9, the current measurement method comprising:
a first step of receiving, by the at least one sensor board, an amount of current measured by the at least one current sensing module;
a second step of digitally converting, by the at least one sensor board, the measured amount of current and transmitting a current value to the mainboard;
a third step of comparing, by the mainboard, the received current value with a pre-stored threshold value to determine whether the current value is abnormal; and
a fourth step of, upon determining that the current value is abnormal, notifying the BMS of the abnormal current value and generating an alarm.

11. A battery pack comprising the integrated current sensing device according to any one of claims 1 to 9.
